# EUROPÄISCHE PATENTSCHRIFT

(11) **EP 1 404 888 B1**
(45) Veröffentlichungstag und Bekanntmachung des Hinweises auf die Patenterteilung: **27.10.2004**
(21) Anmeldenummer: 02737919.7
(22) Anmeldetag: 04.04.2002
(51) Int. Cl.: C22C 47/00, C04B 41/51

(54) **METALL-KERAMIK-VERBUNDWERKSTOFF**
METAL-CERAMIC COMPOSITE MATERIAL
MATERIAU COMPOSITE METAL-CERAMIQUE

(30) Priorität: 26.05.2001 DE 10125815
(43) Veröffentlichungstag der Anmeldung: 07.04.2004
(73) Patentinhaber: DaimlerChrysler AG, 70567 Stuttgart (DE)
(72) Erfinder: NEUMANN, Nicole, 73732 Esslingen (DE); SCHLEGL, Martin, 73635 Rudersberg (DE); THIEMANN, Karl-Heinz, 71404 Korb (DE)
(86) Internationale Anmeldenummer: PCT/EP2002/003742
(87) Internationale Veröffentlichungsnummer: WO 2002/097147

(56) Entgegenhaltungen:
- EP-A- 0 739 668
- US-A- 4 142 022
- US-A- 4 740 428
- US-A- 4 757 790
- US-A- 5 618 635

## Beschreibung

Die Erfindung betrifft einen Metall-Keramik-Verbundwerkstoff nach dem Oberbegriff des Patentanspruchs 1.

Aus der EP 739 668 A2 ist eine Zylinderlaufbuchse aus einem Metall-Keramik-Verbundwerkstoff bekannt. Diese Zylinderlaufbuchse wird hergestellt, indem eine poröse keramische Preform aus einem keramischen Pulver und keramischen Fasern auf konventionelle Weise erzeugt wird und anschließend mit einem flüssigen Metall infiltriert wird. Die so entstandene Zylinderlaufbuchse wird nun als Kern in ein Gießwerkzeug eingesetzt und mit flüssigem Metall umgossen. Das hieraus resultierende Bauteil ist ein Zylindergehäuse, das lokal im Bereich der Laufbuchse durch den Verbundwerkstoff verstärkt ist.

Der Nachteil derartiger Verbundwerkstoffe ist die mikroskopische Anbindung zwischen der Preform und der metallischen Phase. Die keramische Preform bildet im Verbundwerkstoff die sogenannte Matrix des Verbundwerkstoffes. Durch nicht optimale Benetzung zwischen der Oberfläche der Matrix und der metallischen Phase (Grenzfläche) wird die theoretische Festigkeit der Werkstoffe nicht erreicht. Ferner weisen derartige Verbundwerkstoffe in allen Volumenrichtungen ein sprödes Bruchverhalten auf, das durch die keramische Matrix bestimmt wird und durch die metallische Phase nicht befriedigend kompensiert werden kann.

Ein weiterer Nachteil derartiger Verbundwerkstoffe äußert sich in Form einer vergleichsweise zu Metallen niedrigen Wärmeleitfähigkeit. Dies führt bei Anwendungen im Bereich von Verbrennungskraftmaschinen oder von Leistungselektronik zu Wärmestauungen und somit in vielen Fällen zu einem Bauteilversagen.

Die Aufgabe der Erfindung besteht demnach darin, einen Metall-Keramik-Verbundwerkstoff bereitzustellen, der gegenüber dem Stand der Technik eine verbesserte Anbindung zwischen einer keramischen Matrix und metallischen Phasen aufweist und sich durch eine höhere Duktilität und Wärmeleitfähigkeit auszeichnet.

Die Lösung der Aufgabe besteht in einem Metall-Keramik-Verbundwerkstoff nach Patentanspruch 1.

Der erfindungsgemäße Metall-Keramik-Verbundwerkstoff (Verbundwerkstoff) weist wenigstens eine metallische Phase und eine keramische Matrix auf. Gebildet wird der Verbundwerkstoff indem eine keramische Preform mit einem flüssigen Metall infiltriert wird. Eine Oberfläche der keramischen Matrix weist eine nadelförmige Struktur auf, in der sich das Metall nach der Infiltration und nach dem Erstarren verklammert. Diese Oberfläche wird im Folgenden als Grenzfläche zwischen der Matrix und der metallischen Phase bezeichnet. Hierdurch wird die Anbindung der keramischen Matrix und der metallischen Phase deutlich erhöht, was sich positiv auf die Festigkeit des Verbundwerkstoffes auswirkt.

Zusätzlich ist die keramische Matrix so ausgestaltet, dass sie mit röhrenförmigen Kanälen, die bevorzugt parallel verlaufen, durchzogen ist. Somit weist der Verbundwerkstoff senkrecht zu den Kanälen eine zusätzlich erhöhte Bruchdehnung auf. Entlang der Kanäle können Zugspannungen oder Druckspannungen ebenfalls durch eine höhere Elastizität kompensiert werden. Die Gefahr eines spontanen und somit katastrophalen Bauteilversagens wird deutlich herabgesetzt.

Bevorzugt sind die Kanäle parallel angeordnet, die Abweichung Ihrer Raumrichtung beträgt in der Regel nicht mehr als 15°, insbesondere nicht mehr als 1°. Im Wesentlichen verlaufen die Kanäle geradlinig, geringfügige Wellenlinien sind jedoch möglich. Spiralförmig angeordnete Kanäle sind denkbar und zweckmäßig, prozeßtechnisch jedoch aufwendiger darzustellen (Anspruch 2).

Eine weitere vorteilhafte Ausgestaltungsform der Erfindung besteht darin, dass mehrere Bündel von Kanälen in verschiedene Raumrichtung, bevorzugt senkrecht zueinander verlaufen. Hierdurch wird zwar das Volumen der Matrix zu Gunsten der metallischen Phase verringert, was die Festigkeit geringfügig herabsetzen kann, die Bruchdehnung des Verbundwerkstoffes wird jedoch erhöht (Anspruch 3). Die Wandstärken zwischen den Kanälen betragen bevorzugt zwischen 0,1 mm und 1mm.

Die Kanäle haben vorzugsweise einen Durchmesser zwischen 0,5 mm und 20 mm. In diesem Bereich kommt das elastische Verhalten des Metalls am besten zur Wirkung. Die einzelnen Kanäle können unterschiedlich dick sein (Anspruch 4).

Üblicherweise haben die Nadeln an der Grenzfläche eine Länge zwischen 10 µm und 1000 µm. Die besonders bevorzugte Nadellänge liegt zwischen 20 µm und 300 µm. Kürzere Nadeln würden keine Verzahnung bewirken, längere Nadeln würden hingegen leichter zum Brechen neigen. Der mittlere Durchmesser der Nadeln beträgt bevorzugt zwischen 0,1 µm und 100 µm (Anspruch 5).

Die keramische und die metallische Phase sind untereinander dreidimensional vernetzt. Zwar sind die metallischen Phasen in den Kanäle isoliert, die Matrix zwischen den Kanälen, ist jedoch porös und ebenfalls von der metallischen Phase durchdrungen. Die keramische Matrix weist eine Porosität zwischen 30 % und 90 %, bevorzugt zwischen 50 % und 70 % auf. Diese Poren sind nahezu vollständig durch die metallische Phase ausgefüllt (Anspruch 6).

Besonders bevorzugt besteht die keramische Preform aus Mullit oder Silikaten, die zur nadelförmigen Ausbildungen (Kristalliten) an der Oberfläche neigen, bzw. derartige Kristallite ohne größeren Aufwand gezüchtet werden können (Anspruch 7).

Die Metalle Magnesium und Aluminium oder ihre Legierungen eignen sich besonders zur Verwendung für den erfindungsgemäßen Verbundwerkstoff. Sie haben ein niedriges spezifisches Gewicht, was insbesondere bei der Anwendung des Verbundwerkstoffes in Leichtbaukonstruktionen von Vorteil ist. Ferner lassen sich diese Metalle gut in Druckgießverfahren vergießen, wodurch die Infiltration der porösen Keramik in vorteilhafter Weise erleichtert wird (Anspruch 8).

Eine weitere zweckmäßige Anwendung des erfindungsgemäßen Verbundwerkstoffs ist ein Kühlkörper nach Patentanspruch 9, der für die Kühlung von Leistungselektronik geeignet ist. Dieser weist Kanäle von einer Oberfläche, auf der elektronische Bauelemente angebracht sind, in Richtung eines Kühlmediums auf. Diese Kanäle bewirken eine hohe Wärmeleitfähigkeit und somit einen schnellen Wärmetransport von der Oberfläche zum Kühlmedium.

Im Folgenden sind vorteilhafte Ausführungsbeispiele der Erfindung beschrieben.

Es zeigen:
- **Fig. 1,**: eine Oberfläche einer keramischen Preform,
- **Fig. 2,**: eine schematische Darstellung der Mikrostruktur eines Verbundwerkstoffes an einer Übergangsstelle zwischen einer Matrix und einem Kanal,
- **Fig. 3,**: eine schematische makroskopische Darstellung eines Verbundwerkstoffes mit parallel verlaufenden Kanälen,
- **Fig. 4,**: eine schematische makroskopische Darstellung eines Verbundwerkstoffes mit parallel verlaufenden Bündeln von Kanälen in unterschiedliche Richtungen und
- **Fig. 5**: eine Kühlkörperanordnung, die mit Leistungselektronik bestückt ist.

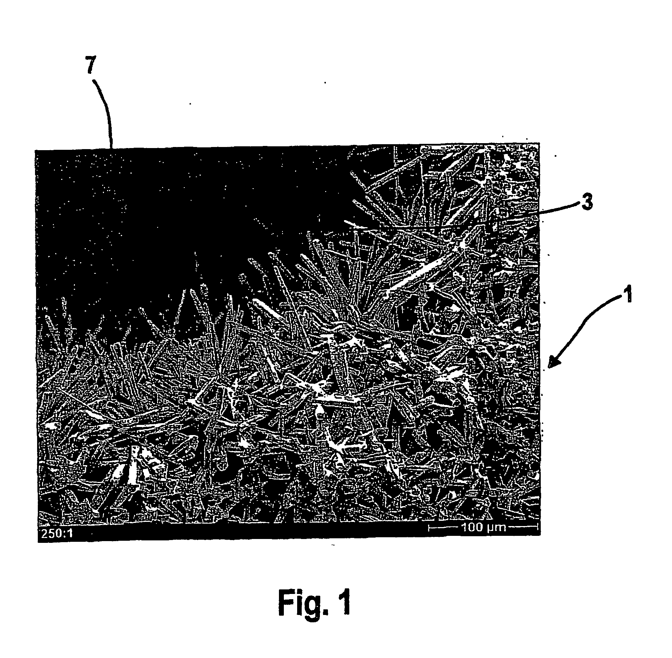

Die Fig. 1 zeigt eine Rasterelektronenmikroskop-Aufnahme einer Oberfläche von einer porösen keramischen Preform 1 im Maßstab 1:250. Die Preform 1 ist bereits so ausgestaltet, dass sie aus Kanälen 7 und aus einer keramischen Matrixstruktur 5 besteht. In dem Ausschnitt in Fig. 1 ist der Übergang zwischen einem Kanal 7 zur keramischen Matrixstruktur 5 dargestellt. Die Oberfläche der Matrix 5 weist nadelförmige Kristallite 3 auf, die sich in das Volumen der Matrix fortsetzen. Im Volumen weist die Matrix zusätzliche körnige Materialanteile auf, die mit den nadelförmigen Kristalliten 3 durch Sinterprozesse fest verbunden sind, was trotz der filigranen Oberfläche zu einer hohen Stabilität der Matrix 5 führt. Die in Fig. 1 dargestellte keramische Matrix besteht aus Mullit.

Die Preform 1 wird zur Herstellung eines erfindungsgemäßen Verbundwerkstoffes 11 mit einem flüssigen Metall vorzugsweise einer gießfähigen Legierung des Aluminiums (z. B. AlSi9Cu3) oder des Magnesiums (z. B. AZ91) infiltriert. Diese Infiltration kann unter Ausnutzung der Kapillarkräfte erfolgen, vorausgesetzt, das keramische Material der Matrix 5 wird durch das flüssige Metall benetzt. Üblicherweise erfolgt die Infiltration der Preform 1 unter Druck. Dies kann in Form einer Gasdruckinfiltration oder durch eine Infiltration im Druckguß- bzw. Squeeze-Casting-Verfahren realisiert werden. In den beiden letzteren Fällen wird die Preform in einen Hohlraum eines entsprechenden Gießwerkzeuges eingelegt und abgestützt.

Das Werkzeug wird verschlossen und das flüssige Metall wird unter Druck (zwischen 20 MPa und 100 MPa) in das Werkzeug gepreßt. Hierbei wird der Hohlraum des Werkzeuges und die Poren der Preform mit flüssigem Metall gefüllt. Nach dem Erstarren wird das Werkzeug geöffnet und der so entstandene Verbundwerkstoff 11 entnommen.

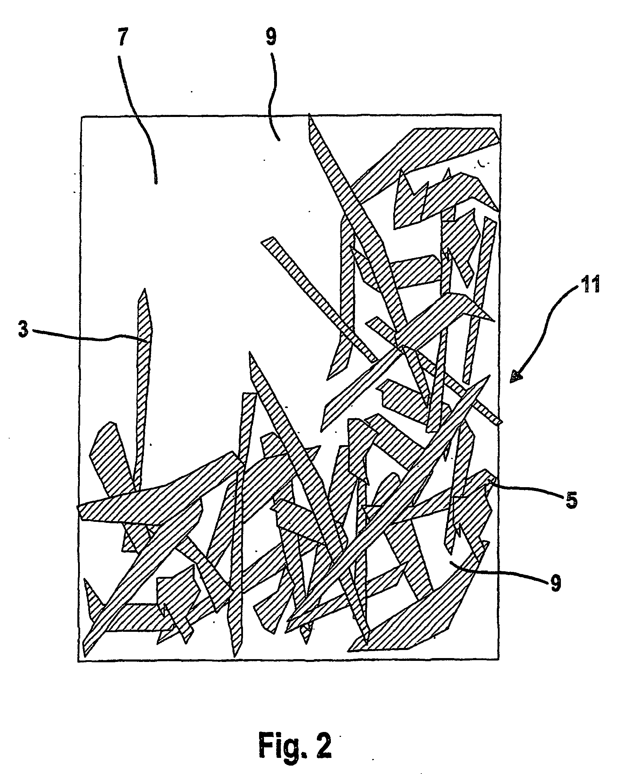

Die Mikrostruktur des Verbundwerkstoffes ist schematisch in Fig. 2 dargestellt. Fig. 2 zeigt ebenfalls den Übergang zwischen der Matrix 5 und einem Kanal 7. Die Nadelstruktur an der Grenzfläche bleibt nach der Infiltration erhalten und führt zu einer Verzahnung, wodurch die Festigkeit des Verbundwerkstoffes 11 erhöht wird. Die Kanäle 7 bestehen nahezu vollständig aus der metallischen Phase 9. Die Matrix 5 ist ebenfalls von der metallischen Phase 9 durchdrungen. Sowohl die Matrix 5 als auch die metallische Phase 9 sind durch den gesamten Verbundwerkstoff 11 dreidimensional miteinander vernetzt.

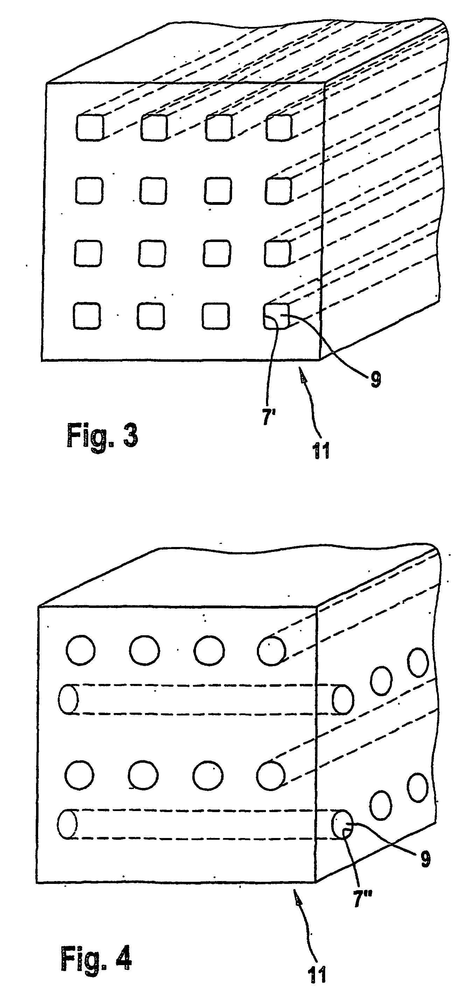

Makroskopische Darstellung des Verbundwerkstoffes 11 in Fig. 3 und Fig. 4 zeigen Anordnungen der Kanäle 7 im Verbundwerkstoff. In Fig. 3 sind die Kanäle 7' parallel angeordnet und laufen unidirektional in eine Richtung. Analog dazu verlaufen in Fig. 4 jeweils parallele Bündel von Kanälen 7'' senkrecht zu einander. Der Querschnitt der Kanäle 7 kann in verschiedenen Formen ausgestaltet sein. Zweckmäßig sind abgerundete, rechteckige Kanäle 7' oder runde Kanäle 7", ovale Querschnitte sind ebenfalls denkbar.

Der Verlauf der Richtungen der Kanäle ist von den Anforderungen eines zu gestaltenden Bauteils abhängig. In Fig. 4 berühren sich die Kanäle 7'' nicht, ein gegenseitiges Durchdringen von Kanälen 7, die in verschiedene Richtungen verlaufen, ist denkbar. Ebenfalls kann ein Verbundwerkstoff mit Kanälen 7 oder Bündeln von Kanälen 7, die in mehr als zwei Raumrichtungen verlaufen, vorteilhaft sein. Der Winkel zwischen den Raumrichtungen kann beliebig gewählt werden.

Besonders vorteilhaft ist es, den erfindungsgemäßen Verbundwerkstoff als Verstärkung in mechanisch, thermisch und/oder tribologisch hoch belasteten Bauteilen, insbesondere Leichtmetallbauteilen einzusetzen. Zweckmäßig ist hierbei eine lokale Verstärkung der Bauteile, wobei zur Herstellung des Verbundwerkstoffes 11 das Druckguß- oder Squeeze-Casting-Verfahren besonders geeignet ist. Durch das Einlegen der Preform 1 in das Gießwerkzeug können gezielt besonders belastete Bauteilbereiche mit der Preform ausgefüllt werden.

Bauteile die zur Verstärkung durch den erfindungsgemäßen Verbundwerkstoff geeignet sind, sind Zylinderkurbelgehäuse, Lagerstühle für Kurbelwellen, Lager von Getriebegehäuse, andere Lager oder Strukturteile, insbesondere von Gußteilen. In eingeschränkten Umfang ist auch die Verstärkung von Zylinderköpfen, die im Allgemeinen im Sandgußverfahren hergestellt werden, möglich. In diesem Fall wird der fertige Verbundwerkstoff in eine Gießform eingelegt und ohne Anwendung eines äußern Drucks mit dem flüssigen Metall umgossen. Analog hierzu ist es möglich Strukturen des Verbundwerkstoffes in Strukturbauteile zu integrieren, die nicht gegossen sind sondern z.B. aus Knetteilen und/oder Blechteilen und/oder aus Kombinationen verschiedener Werkstofftypen bestehen.

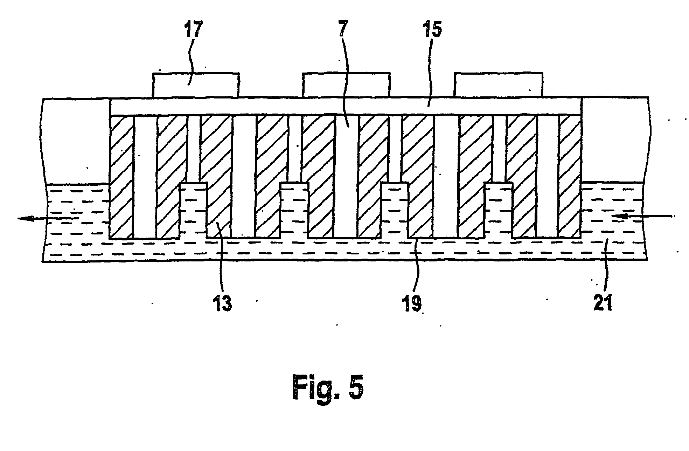

Eine weitere zweckmäßige Anwendung des erfindungsgemäßen Verbundwerkstoffes ist eine Kühlkörperanordnung nach Fig. 5. Der Kühlkörper 13, der aus dem erfindungsgemäßen Verbundwerkstoff besteht, ist an einer Oberfläche mit einer elektrisch isolierenden Schicht 15 versehen. Bevorzugt besteht die Schicht 15 aus Aluminiumnitrid oder Siliziumkarbid, dies sind Materialien, die eine hohe Wärmeleitfähigkeit aufweisen. Auf der isolierenden Schicht 15 sind Leistungselektronik-Bauteile 17 montiert, bei deren Betrieb eine große Menge an Wärmeenergie auftritt.

Zur besseren Abführung der auftretenden Wärmeenergie ist der erfindungsgemäße Kühlkörper so ausgestaltet, dass Kanäle 7, die mit metallischer Phase befüllt sind, von der Isolierenden Schicht 15 in Richtung eines Kühlmediums 21 verlaufen. Bevorzugt sind die Kanäle 7 mit Aluminium oder einer Aluminiumlegierung oder anderen Metallen mit einer hohen Wärmeleitfähigkeit (z. B. Kupfer) befüllt. Das Kühlmedium 21 besteht in der Regel aus Wasser, das mit Zusätzen gegen Korrosion versehen ist und es fließt in Richtung der Pfeile durch Zapfen 19 des Kühlkörpers 13. Die Zapfen 19 dienen zur Vergrößerung einer Oberfläche durch die die Wärmeenergie an das Kühlmedium abgegeben wird. Die Kanäle 7 beschleunigen den Wärmetransport von der Isolierschicht 15 zum Kühlmedium 21 , da die metallische Phase 9 eine höhere Wärmeleitfähigkeit aufweist als die übrigen Bereiche des Verbundwerkstoffes.

Einen Weiteren Vorteil, den der erfindungsgemäßen Kühlkörper 13 gegenüber einem herkömmlichen Kühlkörper aus Kupfer oder reinem Aluminium aufweist, ist sein verhältnismäßig geringer Ausdehnungskoeffizient parallel zur Isolierschicht 15. Dies führt zu einer Minimierung von thermischen Spannungen zwischen dem Kühlkörper 13 und der Isolierschicht 15 und letztlich zu einer Erhöhung der Bauteil-Lebensdauer.

## Patentansprüche

1. Metall-Keramik-Verbundwerkstoff mit einer keramischen Matrix (5) und wenigstens einer metallischen Phase (9), die voneinander durchdrungen sind und zusammen einen nahezu dichten Körper bilden und an Grenzflächen miteinander in Berührung stehen
**dadurch gekennzeichnet, dass**
- die Grenzflächen nadelförmig ausgebildet sind und
- die metallischen Phasen (9) und die keramische Matrix (5) durch die nadelförmigen Grenzflächen verzahnt sind und
- dass der Verbundwerkstoff von röhrenförmigen Kanälen (7) durchzogen ist,
- die durch wenigstens eine metallische Phase (9) gefüllt sind.

2. Metall-Keramik-Verbundwerkstoff nach Anspruch 1,
**dadurch gekennzeichnet, dass**
die röhrenförmigen Kanäle (7) im Wesentlichen parallel ausgerichtet sind.

3. Metall-Keramik-Verbundwerkstoff nach Anspruch 1 oder 2,
**dadurch gekennzeichnet, dass**
die Bündel von parallel verlaufenden Kanälen (7) in wenigstens eine Raumrichtung verlaufen.

4. Metall-Keramik-Verbundwerkstoff nach einem der vorhergehenden Ansprüche,
**dadurch gekennzeichnet, dass**
die Kanäle (7) einen Durchmesser zwischen 0,5 mm und 20 mm aufweisen.

5. Metall-Keramik-Verbundwerkstoff nach einem der vorhergehenden Ansprüche,
**dadurch gekennzeichnet, dass**
die Länge der Nadeln (3) zwischen 10 µm und 1000 µm liegt.

6. Metall-Keramik-Verbundwerkstoff nach einem der vorhergehenden Ansprüche,
**dadurch gekennzeichnet, dass**
die metallischen Phasen und die keramische Matrix untereinander dreidimensional vernetzt sind.

7. Metall-Keramik-Verbundwerkstoff nach einem der vorhergehenden Ansprüche,
**dadurch gekennzeichnet, dass**
die keramische Matrix aus Mullit oder Silikaten besteht.

8. Metall-Keramik-Verbundwerkstoff nach einem der vorhergehenden Ansprüche,
**dadurch gekennzeichnet, dass**
die metallischen Phasen aus Aluminium oder Magnesium oder Legierungen dieser Metalle bestehen.

9. Kühlkörper, insbesondere für Leistungselektronik, bestehend aus einem Verbundwerkstoff nach einem der Ansprüche 1 bis 8,
**dadurch gekennzeichnet, dass**
der Kühlkörper Kanäle (7) aufweist, die von einer Oberfläche, die durch Wärmeenergie beaufschlagt wird, in Richtung eines Kühlmediums verlaufen.

## Claims

1. Metal-ceramic composite material having a ceramic matrix (5) and at least one metallic phase (9), which are intermingled with one another, together form a virtually completely dense body and are in contact with one another at boundary surfaces, **characterized in that**
- the boundary surfaces are needle-shaped (acicular), and
- the metallic phases (9) and the ceramic matrix (5) are interlocked by the acicular boundary surfaces, and
- **in that** tubular passages (7) pass through the composite material,
- which passages are filled by at least one metallic phase (9).

2. Metal-ceramic composite material according to Claim 1, **characterized in that** the tubular passages (7) are oriented substantially parallel to one another.

3. Metal-ceramic composite material according to Claim 1 or 2, **characterized in that** the sets of passages (7) running parallel to one another run in at least one spatial direction.

4. Metal-ceramic composite material according to one of the preceding claims, **characterized in that** the passages (7) have a diameter of between 0.5 mm and 20 mm.

5. Metal-ceramic composite material according to one of the preceding claims, **characterized in that** the length of the needles (3) is between 10 µm and 1000 µm.

6. Metal-ceramic composite material according to one of the preceding claims, **characterized in that** the metallic phases and the ceramic matrix are interlinked with one another in three dimensions.

7. Metal-ceramic composite material according to one of the preceding claims, **characterized in that** the ceramic matrix consists of mullite or silicates.

8. Metal-ceramic composite material according to one of the preceding claims, **characterized in that** the metallic phases consist of aluminium or magnesium or alloys of these metals.

9. Heat sink, in particular for power electronics, consisting of a composite material according to one of Claims 1 to 8,
**characterized in that** the heat sink has passages (7) which run from a surface which is exposed to thermal energy towards a cooling medium.

## Revendications

1. Matériau composite métal-céramique comportant une matrice en céramique (5) et au moins une phase métallique (9), qui sont pénétrées l'une par l'autre et qui forment conjointement un corps à peu près étanche et sont en contact l'une avec l'autre au niveau de leurs surfaces périphériques,
**caractérisé en ce que**
- les surfaces périphériques sont configurées en forme d'aiguilles et
- les phases métalliques (9) et la matrice en céramique (5) sont dentelées par les surfaces périphériques en forme d'aiguilles et
- **en ce que** le matériau composite est traversé par des canaux (7) en forme de tubes,
- lesquels sont remplis par au moins une phase métallique (9).

2. Matériau composite métal-céramique selon la revendication 1,
**caractérisé en ce que**
les canaux (7) en forme de tubes sont orientés essentiellement parallèlement.

3. Matériau composite métal-céramique selon la revendication 1 ou 2,
**caractérisé en ce que**
les faisceaux de canaux (7) qui s'étendent parallèlement s'étendent dans au moins une direction spatiale.

4. Matériau composite métal-céramique selon une des revendications précédentes,
**caractérisé en ce que**
les canaux (7) présentent un diamètre compris entre 0,5 mm et 20 mm.

5. Matériau composite métal-céramique selon une des revendications précédentes,
**caractérisé en ce que**
la longueur des aiguilles (3) est comprise entre 10 µm et 1000 µm.

6. Matériau composite métal-céramique selon une des revendications précédentes,
**caractérisé en ce que**
les phases métalliques et la matrice en céramique sont réticulées les unes sous les autres en trois dimensions.

7. Matériau composite métal-céramique selon une des revendications précédentes,
**caractérisé en ce que**
la matrice en céramique est constituée de mullite ou de silicates.

8. Matériau composite métal-céramique selon une des revendications précédentes,
**caractérisé en ce que**
les phases métalliques sont constituées d'aluminium ou de magnésium ou d'alliages de ces métaux.

9. Dissipateur thermique, notamment pour l'électronique de puissance, constitué d'un matériau composite selon une des revendications 1 à 8,
**caractérisé en ce que**
le dissipateur thermique présente des canaux (7) qui s'étendent à partir d'une surface, laquelle est sollicitée par l'énergie thermique, dans la direction d'une matière de refroidissement.
